# EUROPEAN PATENT APPLICATION

(11) **EP 4 668 335 A1**
(43) Date of publication of application: **24.12.2025**
(21) Application number: 24182921.7
(22) Date of filing: 18.06.2024
(51) Int. Cl.: H01L 23/64, H01L 23/15, H01L 23/48, H01L 23/498, H01L 25/065

(54) **A PACKAGE COMPRISING A FIRST AND A SECOND SEMICONDUCTOR DIE, WHEREIN A GALVANIC COUPLING IS PROVIDED BETWEEN THOSE SEMICONDUCTOR DIES, AS WELL AS A CORRESPONDING METHOD**

(71) Applicant: Nexperia B.V., 6534 AB Nijmegen (NL)
(72) Inventor: Gajanana, Deepak, Nijmegen (NL); Lam, Kan Wae, 6534 AB Nijmegen (NL); Flauta, Randolph Estal, Hong Kong (HK); Man, Chun Nga, Hong Kong (HK)
(74) Representative: Pjanovic, Ilija

(57) **Abstract**

A package, comprising a glass substrate, first and second electrically conductive interconnect route layers provided on a top side of said glass substrate, wherein the first and second electrically conductive interconnect route layers are isolated from each other, first and second electrically conductive top plates provided on said top side of said glass substrate, a first semiconductor die having at least two terminals, wherein a first of said two terminals is connected to the first electrically conductive interconnect route layer and a second of said at least two terminals is connected to said first electrically conductive top plate, a second semiconductor die having at least two terminals, wherein a first of said two terminals is connected to the second electrically conductive interconnect route layer and a second of said at least two terminals is connected to said second electrically conductive top plate, a first via through said glass substrate for enabling an electrical connection from a bottom side of said glass substrate to said first electrically conductive plate, a second via through said glass substrate for enabling an electrical connection from said bottom side of said glass substrate to said second electrically conductive plate, a third electrically conductive plate on top of the first and second semiconductor dies such that said first and second semiconductor dies are located between said third electrically conductive plate and the glass substrate, wherein said third electrically conductive plate is oriented such that a capacitive coupling is provided between, said first electrically conductive plate and said third electrically conductive plate, and said second electrically conductive plate and said third electrically conductive plate.

## Description

### Technical field

The present disclosure generally relates to the field of packaging and, more specifically, to leaded and leadless packages that comprise at least two galvanic coupled semiconductor dies.

### Background

Isolation plays an important role in ensuring seamless operations between semiconductor circuits operating at different voltage levels, allowing data exchange while preventing undesired current flow. Traditional methods have relied on a spectrum of components such as optocouplers, capacitors, transformers, or magnetic coils to achieve this isolation. However, these methods have inherent limitations, including bulkiness, limited bandwidth, and susceptibility to environmental factors like temperature and electromagnetic interference, EMI.

An alternative approach involves integrating isolators directly within semiconductor components. This method utilizes the inherent properties of the semiconductor materials, utilizing the metal capacitance and insulating layers to fashion a capacitive-based insulator. By doing so, the need for bulky external components is circumvented, leading to more compact designs and potentially enhanced performance.

Despite the advantages of integrated isolators, challenges persist. One significant limitation arises from the constraints on insulation distance within the semiconductor device itself. This limitation stems from the reliance on metal layers within the semiconductor's structure to create the necessary insulation barriers. As a result, the distance through insulation is inherently limited, posing risks of electrostatic discharge, ESD, and compromising the overall insulation performance.

In the realm of galvanic isolation applications,surface mount leaded packages are widely accepted as the norm.The popularity stems from the fact that they can be compatible with automated assembly process and are smaller in size compared to through-hole counterparts. Leaded packages offer several advantages: Compatibility with legacy designs, meaning older circuit design techniques could be reused. Leaded packages are more mechanically robust and stable and suitable for applications in harsh environments for e.g. mechanical stress or high temperatures. Leaded packages can be soldered manually making troubleshooting and installation easier. They typically have larger footprint compared to leadless packages but this aids in heat dissipation. Leaded packages are more versatile in terms of pin and pad configurations and wirebonding the die to the package ensuring optimal integration into the overall system architecture. Moreover, the pursuit of leadless packaging configurations introduces additional complexities. Leadless packages, while offering potential benefits such as reduced footprint and improved thermal management, present unique engineering challenges. One such challenge is the need for a split in the lead frame to accommodate the configuration, which can complicate manufacturing processes and introduce reliability risks. Additionally, the exposed pad characteristic of leadless packages necessitates specialized coatings to protect against environmental factors and ensure long-term reliability.

Furthermore, considerations of creepage and clearance become of importance in leadless package designs. Creepage refers to the distance that a surface-contaminating substance, such as dust or moisture, can travel along the surface of an insulating material. Clearance, on the other hand, denotes the shortest distance between two conductive parts or between a conductive part and the grounded surface. In leadless packages, where space is at a premium, maintaining adequate creepage and clearance distances becomes a critical design consideration to prevent electrical breakdown and ensure safety and reliability.

In view of these challenges, there is a growing demand for innovative solutions that address the limitations of conventional isolation techniques and overcome the hurdles associated with leadless package designs.

### Summary

It would be advantageous to achieve a package that overcomes the difficulties as addressed above. It would further be advantageous to achieve a corresponding method of manufacturing such a package.

In a first aspect of the present disclosure, there is provided a package, comprising: a glass substrate; first and second electrically conductive interconnect route layers provided on a top side of said glass substrate, wherein the first and second electrically conductive interconnect route layers are isolated from each other; first and second electrically conductive top plates provided on said top side of said glass substrate; a first semiconductor die having at least two terminals, wherein a first of said two terminals is connected to the first electrically conductive interconnect route layer and a second of said at least two terminals is connected to said first electrically conductive top plate; a second semiconductor die having at least two terminals, wherein a first of said two terminals is connected to the second electrically conductive interconnect route layer and a second of said at least two terminals is connected to said second electrically conductive top plate; a first via through said glass substrate for enabling an electrical connection from a bottom side of said glass substrate to said first electrically conductive plate; a second via through said glass substrate for enabling an electrical connection from said bottom side of said glass substrate to said second electrically conductive plate; a third electrically conductive plate provided on top of the first and second semiconductor such that the first and second semiconductor dies are located between said top electrically conductive plate and the glass substrate, wherein said third electrically conductive plate is oriented such that a capacitive coupling is provided between: said first electrically conductive plate and said third electrically conductive plate, and said second electrically conductive plate and said third electrically conductive plate.

When glass is utilized as a substrate material, it offers several advantages. Firstly, glass, being an insulating material, effectively isolates the internal components of the semiconductor device from the external environment. This isolation is further enhanced when combined with electromagnetic compatibility, EMC, measures, which shield the device from external electromagnetic interference.

Another benefit of using glass as a substrate is that it eliminates the need for additional coatings to protect the device from environmental factors. In traditional packages, an exposed pad is often present, requiring specialized coatings to safeguard against moisture, dust, and other contaminants. However, in configurations utilizing a glass substrate, this exposed pad is no longer necessary.

The glass substrate itself provides inherent protection, acting as a barrier between the sensitive internal components of the device and the external surroundings.

The glass substrate may also provide structural strength, for example during molding of the semiconductor dies.

By leveraging glass as a substrate material and, possibly, integrating EMC measures, semiconductor devices can achieve robust isolation from the outside world without relying on additional coatings or exposed pads. This not only simplifies the manufacturing process but also enhances the reliability and longevity of the device, making it well-suited for a variety of applications in demanding environments.

The inventors have found that it may be beneficial to create a galvanic isolation between the first and second semiconductor dies. This is accomplished using the third electrically conductive plate provided on top of the first and second semiconductor dies such that said first and second semiconductor dies are located between said third electrically conductive plate and the glass substrate. In such a way, there is a capacitive coupling between the first electrically conductive top plate and the third plate. There is also a capacitive coupling between the second electrically conductive top plate and the third plate.

In other words, the connection between the two semiconductor dies may be viewed as two in series connected capacitors. This enables galvanic isolation between the semiconductor dies and, at the same time, enable data to be exchanged between the semiconductor dies.

The galvanic connection includes the capacitive coupling between the third plate and the first semiconductor die, more specifically to the first electrically conductive top plate and includes the capacitive coupling between the third plate and the second semiconductor die, more specifically the second electrically conductive top plate.

It may be noted that the creation of the capacitive coupling between the semiconductor dies does not require metal leads extending from the semiconductor dies. The electrically conductive top plates may be implemented as metal pads to which the corresponding semiconductor dies are directly mounted, for example using a technique as a surface mount technology.

The present disclosure is not limited to a specific example of a semiconductor die. The semiconductor die could, for example, be related to Integrated Circuits, which are chips that contain various electronic components such as transistors, resistors, capacitors, and diodes integrated onto a single semiconductor substrate.

Other examples include microprocessors and microcontrollers. These are specialized ICs designed to perform processing tasks in digital electronic devices. They contain a central processing unit, CPU, memory, and input/output peripherals on a single chip.

Even further examples include Power Devices. Semiconductor dies designed for power applications, such as power MOSFET, i.e. Metal-Oxide-Semiconductor Field-Effect Transistors, insulated-gate bipolar transistors, IGBTs, and diodes.

The present disclosure is directed to a leaded and a leadless package. A leadless package, in the context of semiconductor dies, refers to a type of packaging used to encapsulate and protect the semiconductor chip without traditional metal leads extending from the package. A leaded package, in the context of semiconductor dies, refers to a type of packaging used to encapsulate and protect the semiconductor chip with traditional metal leads extending from the package.

In the present scenario, at least two semiconductor dies are provided in the package. Each semiconductor die is mounted on the glass substrate of the package substrate. The glass substrate contain multiple electrically conductive top plates for each die, facilitating electrical capacitive connections between the semiconductor dies. The capacitive coupling is obtained by utilizing a third plate.

In an example, the glass substrate is a monolithic glass substrate.

A monolithic glass substrate refers to a single piece of glass that serves as the foundation or base for the semiconductor dies. A monolithic glass substrate is used to provide a stable and reliable base for mounting and integrating the semiconductor dies.

These substrates may be made from high-purity glass materials, such as borosilicate or quartz, which offer improved thermal and mechanical properties, as well as compatibility with various fabrication processes. Monolithic glass substrates can be customized with precise dimensions, surface finishes, and features to accommodate specific device requirements.

In a further example, any of said terminals of said first and second semiconductor die are connected to said corresponding first or second electrically conductive interconnect route layers or said first or second electrically conductive top plates using an adhesive.

Electrically conductive adhesives may be materials formulated to provide both mechanical bonding and electrical conductivity when used to join two surfaces together. These adhesives may typically contain conductive particles, such as silver or nickel, dispersed within a polymer matrix.

When applying an electrically conductive adhesive between a semiconductor die and an electrically conductive plate, the adhesive forms a bond between the surfaces while also creating an electrical pathway. This enables the transfer of electrical signals or power between the corresponding semiconductor die and the electrically conductive plate. The adhesive may thus serve as both a bonding agent and a conductive medium, allowing for a reliable and electrically efficient connection.

In a further example, any of said terminals of said first and second semiconductor die are connected to said corresponding first or second electrically conductive interconnect route layers or said first or second electrically conductive top plates using solder material.

Soldering involves melting a solder material, typically an alloy containing tin and lead, or lead-free alternatives, and using it to create a metallurgical bond between the semiconductor die and the electrically conductive plate.

In a further example, the package further comprises a mold surrounding said first and second semiconductor die.

The mold, also referred to as an encapsulant or encapsulation material, may serve different functions in semiconductor packaging. One of the purposes of the mold is to protect the semiconductor die from external environmental factors such as moisture, dust, mechanical damage, and chemical exposure. By encapsulating the die in a protective material, its longevity and reliability can be improved. The mold material may also aid to electrically isolate the semiconductor die from its surroundings, preventing unintended electrical contact or interference with other components or conductive elements. Further, the encapsulant may provide mechanical support to the semiconductor die, helping to absorb mechanical stresses and shocks encountered during handling, assembly, and operation.

In a further example, a distance between said third electrically conductive plate and any of said first and second electrically conductive top plates is preferably upto 40% of the height of the package, and can be varied depending on the isolation rating requirements . This allows for a range of dimensions of the components of the package (such as the height/thickness of the glass substrate, the height/thickness of the mold compound, the height/thickness of the semiconductor die(s), etc) which can be adjusted but does not reduce performance of the package.

The advantage hereof is that a capacitive coupling between the semiconductor dies can be warranted.

In yet another example, a shape of said third electrically conductive plate is any of rectangular, square, ellipse, circle, irregular polygons.

In a further example, the first and second semiconductor dies are mounted to said substrate using a flip-chip process.

The flip-chip technology is a method, wherein the semiconductor die is electrically connected to the glass substrate by flipping the die upside down and attaching it directly to the glass substrate using conductive means, typically made of solder or conductive adhesives.

In the context of creating a package, the flip-chip process allows for direct electrical connections between the semiconductor die and the plates present on the glass substrate without the need for traditional wire bonding or lead frames.

In a second aspect of the present disclosure, there is provided a method of manufacturing a package in accordance with any of the previous examples, wherein said method comprises the steps of: providing said glass substrate; providing said first and second via through said glass structure; depositing said first and second electrically conductive interconnect route layers on said top side of said glass substrate and depositing said first and second electrically conductive top plates on said top side of said glass substrate; mounting said first and second semiconductor dies on said substrate, depositing said third electrically conductive plate on top of the first and second semiconductor dies such that said first and second semiconductor dies are located between said third electrically conductive plate and the glass substrate.

It is noted that the advantages as explained with respect to the first aspect of the present disclosure, being the leaded and leadless packages, are also applicable to the second aspect of the present disclosure, being the method of manufacturing a leaded and/or a leadless package.

In an example hereof, the glass substrate is a monolithic glass substrate.

In another example, the step of mounting said first and second semiconductor die comprises: mounting any of said terminals of said first and second semiconductor die to said corresponding first or second electrically conductive interconnect route layers or said first or second electrically conductive top plates using an adhesive.

In a further example, the step of mounting said first and second semiconductor die comprises: mounting any of said terminals of said first and second semiconductor die to said corresponding first or second electrically conductive interconnect route layers or said first or second electrically conductive top plates using solder material.

In an example, the method further comprises the step of: providing molding to said first and second semiconductor dies such that said package further comprises a mold surrounding said first and second semiconductor die.

In another example, a distance between said bottom electrically conductive plate and any of said first and second electrically conductive top plates is in the order of 8um for a requirement of 4kVrms (it is assumed that the dielectric strength of glass is around 500Vrms/um).

In an example, the step of mounting said first and second semiconductor dies on said substrate uses a flip-chip process
In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Figs. 1a and 1b shows an example of a package in accordance with the present disclosure;
Figs. 2a-2c disclose formation of vias, routing interconnects and capacitive contacts in accordance with the present disclosure;
Figs. 3a-3e disclose a semiconductor package assembly in accordance with the present disclosure.
Figs. 4a - 4h discloses the variations on the bottom electrically conductive plate 11 according to an embodiment of the present invention.
Fig. 5 disclose a completed leaded package according to the present invention.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

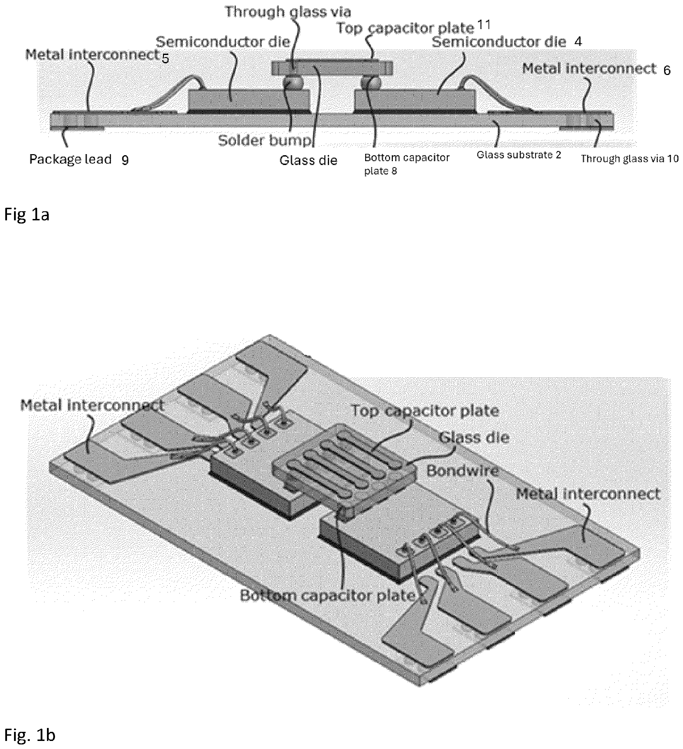

Figs. 1a and 1b show an example of a leaded and a leadless package 1 in accordance with the present disclosure.

A leadless package refers to a type of packaging for semiconductor dies, or integrated circuits that lacks traditional lead wires extending from the semiconductor dies. Instead of having protruding leads, a leadless package typically has metal pads or terminals on its surface for electrical connections. A leaded package, on the other hand, refers to a type of packaging for semiconductor dies, or integrated circuits that has traditional lead wires extending from the semiconductor dies. Instead of having protruding leads.

Packages offer advantages such as smaller size, higher density, and better thermal performance compared to traditional leaded packages.

The package comprises a glass substrate 2. The package incorporates a glass substrate, providing a durable and thermally stable foundation for the semiconductor dies 3, 4.

Further, first and second electrically conductive interconnect route layers 5, 6 are provided on a top side of said glass substrate 2, wherein the first and second electrically conductive interconnect route layers 5, 6 are isolated from each other. This aspect involves the inclusion of distinct electrically conductive interconnect route layers on the top side of the glass substrate, ensuring separate pathways for electrical connections to the respective semiconductor dies without interference.

Next, first and second electrically conductive top plates 7, 8 are provided on a bottom side of the third electrically conductive capacitor plate. These, facilitate electrical connections within the package.

A first semiconductor die 3 is provided having at least two terminals, wherein a first of said two terminals is connected to the first electrically conductive interconnect route layer and a second of said at least two terminals is connected to said first electrically conductive top plate: This component encompasses the presence of a semiconductor die with multiple terminals, establishing connections between specific terminals and designated electrically conductive layers or plates within the package.

A second semiconductor die 4 is provided having at least two terminals, wherein a first of said two terminals is connected to the second electrically conductive interconnect route layer and a second of said at least two terminals is connected to said second electrically conductive top plate.

Similarly to the first semiconductor die, this aspect involves another semiconductor die with multiple terminals, with connections established between its terminals and specific electrically conductive layers or plates within the package.

Figs. 1a and 1b illustrate an embodiment according to an aspect of the present invention where the terminals of both the first and second semiconductor dies are positioned on one side (surface) of said semiconductor dies, namely the side facing away from the glass substrate 2 in the package 1. This allows the opposite side of the semiconductor die to be attached to the glass substrate 2. This means that bond wires, or other connections means are necessary in order to connect both electrically conductive interconnect route layers 5, 6 and the electrically conductive top plates 7, 8. This has the effect of optimizing the space within the package. However, the semiconductor dies may have terminals on other sides (or surfaces) of said semiconductor dies which can also be connected to the electrically conductive interconnect route layers 5, 6 and/or the electrically conductive top plates 7, 8 through other means, such as bond wires, solder balls, or other adhesive means. Such configurations may lead to more effective space usage within the package. In accordance to another embodiment of the present invention the conductive plates 7, 8 may be on the semiconductor surface facing the glass substrate, and thus could be positioned on top of the electrically conductive interconnect router layers 5, 6. Such a connection can made using solder balls and other adhesive methods.

A first via 9 is provided through said glass substrate for enabling an electrical connection from a bottom side of said glass substrate to said first electrically conductive plate. This aspect refers to a via passing through the glass substrate, facilitating an electrical connection from the bottom side of the substrate to the first electrically conductive top plate. In a leaded package, terminals # are present on the bottom side of said glass substrate and configured to use the first via 9 to pass an electrical connection between said terminal # and the electrically conductive interconnect route layer 5.

A second via 10 is provided through said glass substrate for enabling an electrical connection from said bottom side of said glass substrate to said second electrically conductive plate. Similar to the first via, this feature entails a via through the glass substrate, enabling an electrical connection from the bottom side of the substrate to the second electrically conductive top plate. In a leaded package, terminals # are present on the bottom side of said glass substrate and configured to use the second via 10 to pass an electrical connection between said terminal # and the electrically conductive interconnect route layer 6.

A third electrically conductive plate 11 is provided on top of the first and second semiconductor dies such that said first and second semiconductor dies are located between said third electrically conductive plate and the glass substrate, wherein said third electrically conductive plate is oriented such that a capacitive coupling is provided between the third plate and the first and, respectively, second electrically conductive top plates. The first and second electrically conductive top plate may form part of the third electrically conductive plate 11 or may be separate components.

The inclusion of the third electrically conductive plate thus allows for a capacitive coupling between the semiconductor dies. Preferably, the this electrically conductive plate is electrically floating.

Finally, a mold 12 may be integrated in the semiconductor package for protective measures.

Thus, in other words, as depicted in Figures 1a and 1b, a singulated structured glass, either in wafer or panel format, may contain multiple layers of via metallization and top and bottom contact layers. The via metallization extends from the top surface to connect with the bottom lead, creating interconnects for the leadless package, and connection terminals for the leaded package.

Positioned within the structured glass package are the top and bottom contact layers (viewed with respect to the glass). Two or more semiconductor dies are attached to the top contact layers and interconnected via the via metallization layers. The glass structure facilitates galvanic capacitive isolation through the top and bottom plates on the glass. Subsequently, the device may undergo molding and singulation processes at the panel or wafer level.

The distance between said bottom electrically conductive plate 11 and any of said first and second electrically conductive top plates 7, 8 is preferably in the order of micrometres to tens of micrometres depending on the isolation requirements and the maximum possible height of the leadless package. The said distance can be varied depending on the requirements of the isolation rating of the product and a special case arises when the said first and second electrically conductive top plates 7,8 could be designed in the silicon dies 3,4.. This allows for a range of dimensions of the components of the leadless package (such as the height/thickness of the glass substrate, the height/thickness of the mold compound, the height/thickness of the semiconductor die(s), etc) which can be adjusted but does not reduce performance of the leadless package.

In a preferred embodiment, a distance (h1) is a height of the semiconductor dies 3,4, a distance (h2) between the bottom side of the bottom electrically conductive plate 11 and the first and/or second electrically conductive top plate 7, 8 is in the order of micrometres to tens of micrometres, depending on the material used. In an embodiment, if the glass is quartz (silicon dioxide, or SiOz), this thickness (h2) could be for example 8 micrometres for an isolation rating of 4kVrms (as it has an electric field strength of around 500 Vrms per micrometre) and can be varied depending on the isolation requirements of the project. The distance (h3) is the height of the said glass substrate, 2, is in the order of hundreds of micrometres and is such that the sum of distances h1, h2 and h3 cannot exceed the height of the designated package. The distance h2 cannot be zero, otherwise the device does not function.

In accordance with another embodiment of the present invention, the bottom electrically conductive plate 11 could also integrate the first and/or second top plates 7, 8 such that the combination of the top and bottom plates form one integrated unit (such as a capacitor).

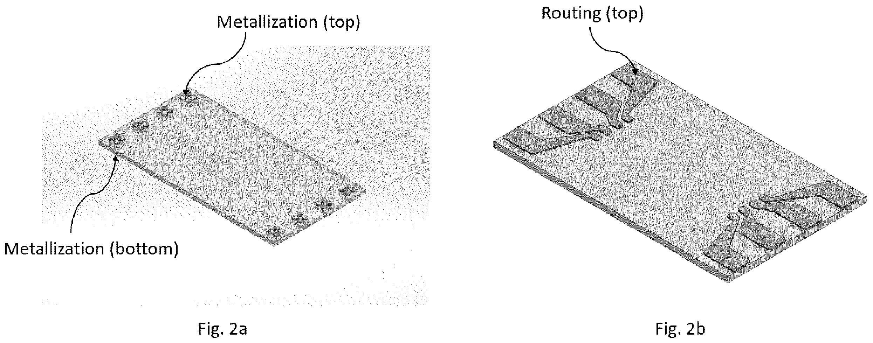

Figs. 2a-2b disclose formation of vias, routing interconnects and capacitive contacts in accordance with the present disclosure.

Fig. 2a shows an example of via metallization and the top side of the glass substrate and the bottom side of the glass substrate. Fig. 2b shows the interconnect layers, i.e. the routing layers deposited on the top side of the glass substrate for connecting the respective vias to the semiconductor dies. Further the top metal plates may be provided for providing one side of the parasitic capacitance that is ultimately created.

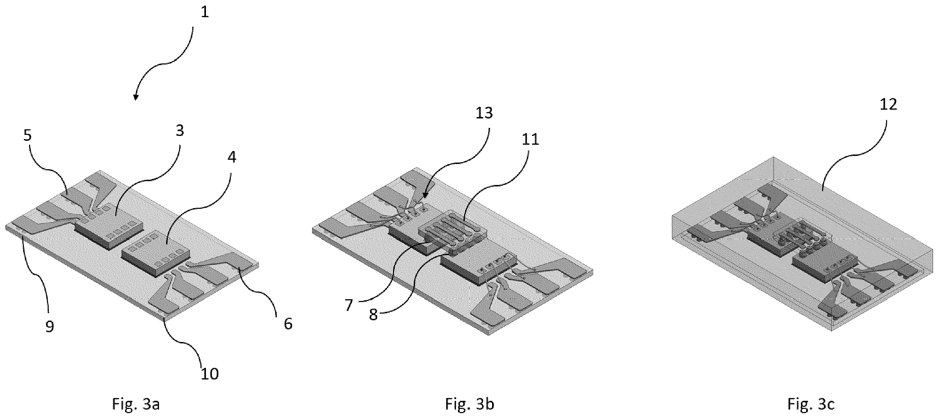

Figs. 3a-3f disclose a semiconductor package assembly in accordance with the present disclosure.

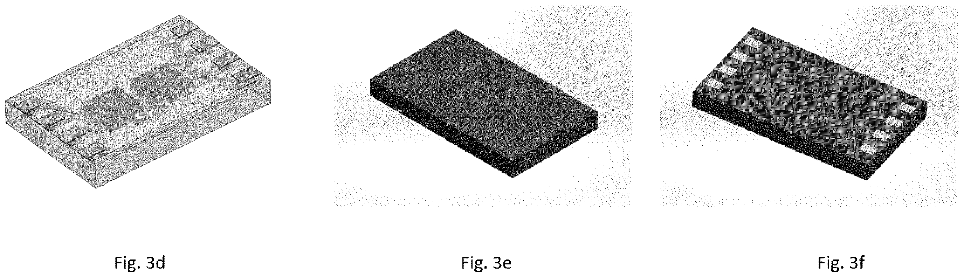

Fig. 3a discloses the concept of attaching the two semiconductor dies 3, 4 to the glass substrate 2 as shown in Fig. 2b. Fig. 3b discloses the placement of the third electrically conductive plate 11, placed on top of the semiconductor dies 3, 4. The side of the semiconductor dies 3,4 coupled to the third electrically conductive plate 11 the surface facing away from the glass substrate 2. The connection between the semiconductor dies 3, 4 and the third electrically conductive plate 11 is made via top plates 7, 8 and the use of solder balls and the like. Fig. 3c discloses the molding concept, i.e. providing molding 12 to the package 1. Fig. 3d discloses the molded unit, which is an example of a package in accordance with the present disclosure. Fig. 3d discloses lead plating, wherein additional electrically conductive layers are provided for interconnection purposes. Finally, Fig 3e discloses the coating of the bottom side of the package and Fig. 3f discloses the top side of the package.

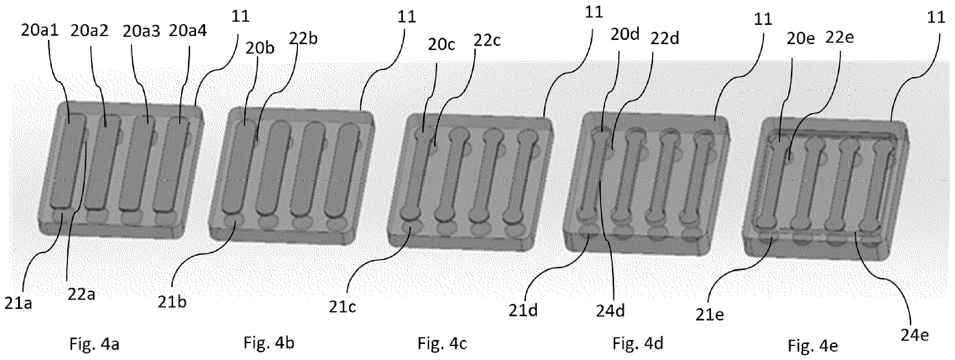

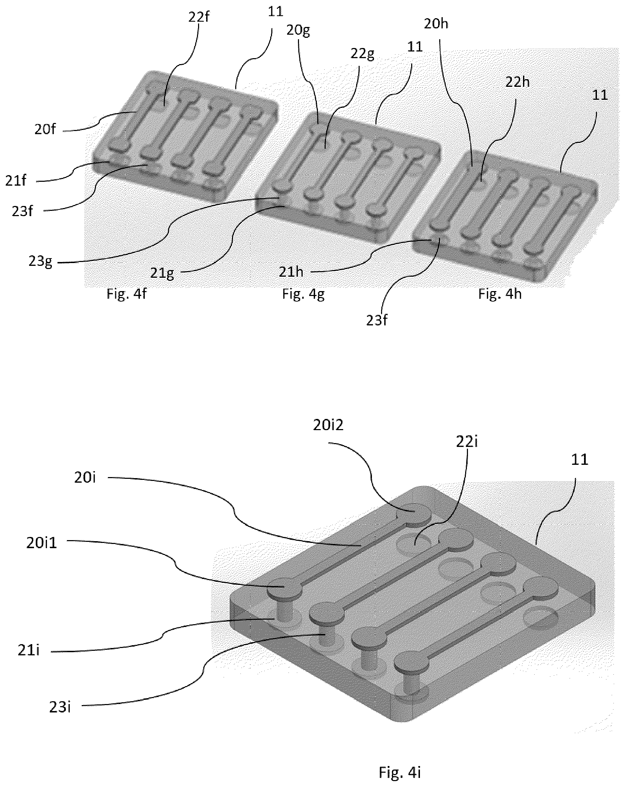

Fig. 4a - 4i discloses the variations on the bottom electrically conductive plate 11 according to an embodiment of the present invention. In these embodiments, said bottom electrically conductive plate 11 may comprise a series of capacitors. In Figure 4a, these series of capacitors (20a1 - 20a4) may be identical capacitors, where each capacitor has two opposite ends, which may be configured to couple with a first connection point 21a and a second connection point 22a, respectively, where the first connection point 21a may be connected to the electrically conductive top plate 7, 8, and the second connection point 22a may be coupled to the remaining electrically conductive top plate 7, 8. As shown in Fig. 4i, the end 20i1 nearest to the connection point 21i may be shorted (i.e., electrically connected to said end), whereas the opposite end 20i2 may not be electrically connected to the connection point 22i. Only one of the ends needs to be shorted. The short may be created by electrically connecting the end 20i1 with connection point 21i through an interconnect 23i. In Fig. 4i this is illustrated as a cylinder with a smaller cross-sectional diameter than the diameter of 20i1, however other variations may be allowed, provided that the device performance does not degrade. For example, the interconnect 20i may share the same cross-sectional diameter as the end 20i1 and connection point 21i.

Figs 4a - 4i discloses different shapes of the capacitors (20a-i) in the bottom electrically conductive plate 11 according to an embodiment of the present invention. Fig. 4a shows a metal strip (20a1 - 20a4) as a capacitor, which may be the simplest to realize from a manufacturing standpoint. Fig. 4b shows a strip (20b) with rounded edges which have the benefit of easier alignment of said capacitor (20b) with the first and second connection points 21b, 22b, as these connection points may also be round or substantially circular. Fig. 4c discloses a capacitor (20c) wherein the connection bar connecting the two ends of said capacitor has a smaller width than the diameter of the substantially round ends. This variation may allow achieve the same performance as the capacitors in Figs 4a-4b while using less material. Such shape may commonly be referred to as a 'dog-bone' shape. Figs 4f - 4h show variations of the dog-bone shape. In Fig. 4f, since the first and second connection points 21f, 22f may be substantially square in shape, the ends of the capacitor 20f may also substantially square. Fig. 4g shows a dog-bone shape wherein the width is smaller than that shown in Fig. 4f. Figs 4f - 4h also disclose the variation where an interconnect (23f - 23h) is provided between an end of the capacitor (20f - 20h) nearest to connection points 21f - 21h. It is noted here that provided that as long as only one end of the capacitor (20a-20i) is shorted, the bottom electrically conductive plate 11 can be used in any (or either) orientation with respect to the semiconductor dies due to symmetry in the package.

As shown in Figs. 4a - 4i, the conductive plate comprising multiple capacitors also has the added benefit that it is no longer necessary to please a series of separate capacitors, thereby saving space in the package, without compromising on the device performance.

The insulation (i.e., the parts which are configured to not electrically conduct) of bottom electrically conductive plate 11 may be constructed of the same material as the glass substrate 2, however, it can also be manufactured from ceramic, or a mixture of glass and ceramic. The bottom electrically conductive plate 11 may also be manufactured such that it is integrated into the glass substrate 2, or manufactured to complement the glass substrate 2. In other words, the glass substrate maybe configured with a receiving area to accept the bottom electrically conductive plate 11, which may be manufactured separately. Alternatively, the bottom electrically conductive plate 11 may be placed on a glass substrate 2 with a flat surface.

Figs. 4d and 4e disclose an embodiment according to the present invention when the series of capacitors 20d, 20e on the conductive plate 11 is embedded into the device, and thus not located at (or on) the surface of said conductive plate. Fig. 4d discloses the configuration where each of the plurality of capacitors 20d may be positioned in an individual trench 24d. In Fig. 4e the plurality of capacitors 20e may all be positioned in the same trench 24e. The trench depth may be from a few hundreds of nanometers to few micrometers with coatings ranging from glass to Silicon nitride or polyimide materials.

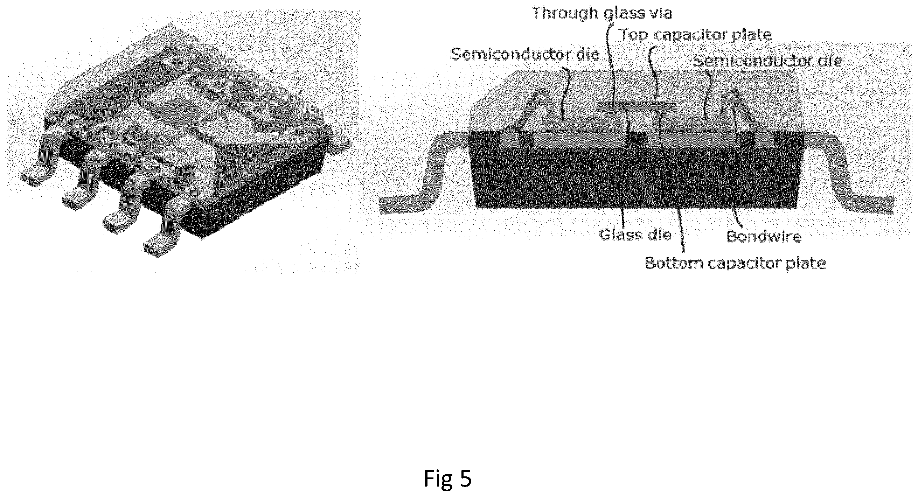

Fig. 5 disclose a completed leaded package according to the present invention, where the package in accordance to any of the previous embodiments are connected to a conductive terminal (or lead) outside the packages

Other variations to the disclosed embodiments can be understood and effected by those skilled in the art in practicing the claimed invention, from a study of the drawings, the disclosure, and the appended claims. The provided figures and descriptions of the embodiments of the invention are illustrative and explanatory to the heart of the invention and should not be seen as limiting the invention thereto. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A package, comprising:
- a glass substrate;
- first and second electrically conductive interconnect route layers provided on a top side of said glass substrate, wherein the first and second electrically conductive interconnect route layers are isolated from each other;
- first and second electrically conductive top plates provided on said top side of said glass substrate;
- a first semiconductor die having at least two terminals, wherein a first of said two terminals is connected to the first electrically conductive interconnect route layer and a second of said at least two terminals is connected to said first electrically conductive top plate;
- a second semiconductor die having at least two terminals, wherein a first of said two terminals is connected to the second electrically conductive interconnect route layer and a second of said at least two terminals is connected to said second electrically conductive top plate;
- a first via through said glass substrate for enabling an electrical connection from a bottom side of said glass substrate to said first electrically conductive plate;
- a second via through said glass substrate for enabling an electrical connection from said bottom side of said glass substrate to said second electrically conductive plate;
- a third electrically conductive plate on top of the first and second semiconductor dies such that said first and second semiconductor dies are located between said third electrically conductive plate and the glass substrate, wherein said third electrically conductive plate is oriented such that a capacitive coupling is provided between:
- said first electrically conductive plate and said third electrically conductive plate, and
- said second electrically conductive plate and said third electrically conductive plate.

2. A package in accordance with claim 1, wherein said third electrically conductive plate is electrically floating.

3. A package in accordance with any of the previous claims, wherein said glass substrate is a monolithic glass substrate.

4. A package in accordance with any of the previous claims, wherein any of said terminals of said first and second semiconductor die are connected to said corresponding first or second electrically conductive interconnect route layers or said first or second electrically conductive top plates using an adhesive.

5. A package in accordance with any of the previous claims, wherein any of said terminals of said first and second semiconductor die are connected to said corresponding first or second electrically conductive interconnect route layers or said first or second electrically conductive top plates using solder material.

6. A package in accordance with any of the previous claims, wherein said leadless package further comprises a mold surrounding said first and second semiconductor die.

7. A leadless package in accordance with any of the previous claims, wherein a distance between said bottom electrically conductive plate and any of said first and second electrically conductive top plates is of the order of is at most 8um for an isolation requirement of 4kVrms .

8. A package in accordance with any of the previous claims, wherein a shape of said third electrically conductive plate is any of rectangular, square, ellipse, circle, irregular polygons.

9. A package in accordance with any of the previous claims, wherein said first and second semiconductor dies are mounted to said substrate using a flip-chip process.

10. A method of manufacturing a package in accordance with any of the previous claims, wherein said method comprises the steps of:
- providing said glass substrate;
- providing said first and second via through said glass structure;
- depositing said first and second electrically conductive interconnect route layers on said top side of said glass substrate and depositing said first and second electrically conductive top plates on said top side of said glass substrate;
- mounting said first and second semiconductor dies on said substrate, and
- depositing a third electrically conductive plate on top of the first and second semiconductor dies such that said first and second semiconductor dies are located between said third electrically conductive plate and the glass substrate ;

11. A method in accordance with claim 10, wherein said step of mounting said first and second semiconductor die comprises:
- mounting any of said terminals of said first and second semiconductor die to said corresponding first or second electrically conductive interconnect route layers or said first or second electrically conductive top plates using an adhesive.

12. A method in accordance any of the claims 10 - 11, wherein said step of mounting said first and second semiconductor die comprises:
- mounting any of said terminals of said first and second semiconductor die to said corresponding first or second electrically conductive interconnect route layers or said first or second electrically conductive top plates using solder material.

13. A method in accordance with any of the claims 10 - 12, wherein said method further comprises the step of:
- providing molding to said first and second semiconductor dies such that said package further comprises a mold surrounding said first and second semiconductor die.

14. A method in accordance with any of the claims 10 - 13, wherein a distance between said bottom electrically conductive plate and any of said first and second electrically conductive top plates of the order of is at most 8um for an isolation requirement of 4kVrms.

15. A method in accordance with any of the claims 10 - 14, wherein said step of mounting said first and second semiconductor dies on said substrate uses a flip-chip process.
